# EUROPEAN PATENT APPLICATION

(11) **EP 4 765 643 A1**
(43) Date of publication of application: **24.06.2026**
(21) Application number: 24221739.6
(22) Date of filing: 19.12.2024
(51) Int. Cl.: H03K 17/96

(54) **CAPACITIVE SENSOR**

(71) Applicant: Microdul AG, 8045 Zürich (CH)
(72) Inventor: SCHELLENBERG, Martin, 8045 Zürich (CH); VITANESCU, Mihai, 8045 Schweiz (CH)
(74) Representative: Mayer, Aline Sophie

(57) **Abstract**

A capacitive sensor comprises an insulating substrate (80), wherein a flat driving electrode (10) is positioned in a driving electrode area (15) on one side of the insulating substrate (80), wherein a flat sensing electrode (20) is positioned in a sensing electrode area (25) on the same side of the insulating substrate (80), wherein the driving electrode area (15) and the sensing electrode area (25) is separated by a distancing area (81) in the plane of the insulating substrate (80). An unconnected one-piece conductive plate (70) is positioned on the opposite side of the insulating substrate (80) covering a surface encompassing the driving electrode area (15) of the driving electrode (10), the sensing electrode area (25) of the sensing electrode (20) as well as the distancing area (81).

## Description

### TECHNICAL FIELD

The present invention relates to a capacitive sensor.

### PRIOR ART

Capacitive sensors are based on capacitive coupling that can detect and measure anything that is to some extent conductive or has a dielectric constant which is different from the air. A capacitive sensor can work based on self-capacitance and on mutual capacitance. In a mutual capacitance-based system, the object to be detected alters the coupling between a driving line and a sensing line, whereas a self-capacitance approach increases the parasitic capacitance to ground.

### SUMMARY OF THE INVENTION

It is an object of the present invention to improve the design of a mutual capacitance-based sensor.

The object is achieved with a capacitive sensor comprising an insulating substrate, wherein a flat driving electrode is positioned in a driving electrode area on one side of the insulating substrate, wherein a flat sensing electrode is positioned in a sensing electrode area on the same side of the insulating substrate, wherein the driving electrode area and the sensing electrode area is separated by a distancing area in the plane of the insulating substrate, wherein an unconnected one-piece conductive plate is positioned on the opposite side of the insulating substrate covering a surface encompassing the driving electrode area of the driving electrode, the sensing electrode area of the sensing electrode as well as the distancing area.

The unconnected one-piece conductive plate is a floating conductive plane allowing for a sensing of an approaching element from the side of the conductive plate. The conductive plate can have holes in it, e.g. for attachment or passing wires for connection purposes. It can have recesses or embossments in the surface and slits inside the plate or slits starting from any edge with the proviso that plate material is positioned below the driving electrode area(s) and sensing driving electrode area(s).

In a view from above on the capacitive sensor, the insulating substrate extends by a predetermined distance beyond the outer edges of the driving electrode area and can extend by a predetermined distance beyond the outer edges of the sensing electrode area. This allows to use a well-defined insulating substrate as dielectric between the electrodes and the conductive plate.

Additionally, in a view from above on the capacitive sensor, the one-piece conductive plate can extend by a predetermined distance beyond the outer edges of the driving electrode area and can extend by a predetermined distance beyond the outer edges of the sensing electrode area. With the insulating substrate in between, having a conductive plate larger than the area of the electrodes provides for a well-defined insulating substrate as dielectric between the electrodes and the conductive plate, especially, when the insulating substrate extends by a predetermined distance beyond the outer edges of the one-piece conductive plate. The conductive plate usually does not extend beyond the insulating substrate as dielectric, but since the insulating substrate extends well beyond the electrode areas, the conductive plate extends beyond the driving and sensing electrode areas. It is not excluded that the conductive plate extends beyond and around the insulating substrate, but in the case of a PCB as insulating plate this necessitates a specific metallic sheet plate.

The flat driving electrode and the flat sensing electrode can be connected with a control unit to obtain and use the detected capacitive changes.

Instead of one single drive electrode, it is possible to provide a number of driving electrode parts. They are then positioned in a distance from the flat driving electrode and from each other driving electrode part within the driving electrode area. The sensor is then very flexible, since only a predetermined number of these driving electrode parts are connected in parallel with 0-ohms resistors or wires to the flat driving electrode. In such a way the driving electrode capacitance is adapted during optimizing the sensor.

The same principle can be applied to the sensing electrode(s) when a number of sensing electrode parts are provided in a distance from the flat sensing electrode and from each other within the sensing electrode area. A predetermined number of these sensing electrode parts can be connected in parallel with 0-ohms resistors or wires to the flat sensing electrode. The said predetermined number of the sensing electrode parts is not necessarily identical to the number of driving electrodes parts, nor shape or size are identical or even similar.

The proposed invention can have inter alia the following advantages:
- The sensor capacitance does not depend on changes of the fringe capacitance between driving and sensing electrodes. They electrode layout is less demanding and less restricted.
- The capacitance of the sensing electrode to the floating plane, i.e. conductive plate, and the capacitance of the driving electrode can be calculated and dimensioned precisely because the insulation material of the printed circuit board PCB is known and the distances between the different electrodes and bottom floating plane are determined by the manufacturing process.
- The possibility to provide multiple small driving and sensing electrode parts can be configured in parallel during the design phase to quickly determine and optimize the capacitance values for the «touch» or «no touch» state. In this way, the capacitance configuration for the final application can be determined in one design iteration. This procedure allows the flat electrodes to be designed as small as possible so that the capacitive load at the output of the driver is kept small.
- There is no requirement for a cover on the bottom side of the PCB. The finger or body can touch the bottom side of the PCB directly, as the bottom plane is isolated from SA and SB implicitly due to PCB construction.
- The capacitance change is always negative when the finger touches the bottom plane, whether directly on the PCB or through another insulating layer which is advantageous in comparison with a number of prior art sensors.
- Through the nearly unrestricted size, the floating bottom plane determines how strongly the human body couples to these regions. In this way, large differences in capacity can be realized between the «touch» or «no touch» states, which makes body (object) detection more robust.
- The floating plane electrode can have an arbitrary shape without affecting the sensing performance, and is therefore simpler to design and manufacture / integrate in the final product.
- The sensor can be better protected, when the PCB including the floating plane can also be covered with an adhesive type tape or other insulating material.
- It is possible that the floating plate can be the last conductive layer on either side of the PCB and the approaching object to be detected is then coming in from that side. The advantage here is, that the metallic floating plane may directly contact the object to be detected without an isolating layer like the PCB solder mask or an overlay.

The sensor arrangement according to the invention can ideally be used for applications such as temperature patches, where a PCB in flexible form is stuck to the human skin with an adhesive tape.

Further embodiments of the invention are laid down in the dependent claims.

### BRIEF DESCRIPTION OF THE DRAWINGS

Preferred embodiments of the invention are described in the following with reference to the drawings, which are for the purpose of illustrating the present preferred embodiments of the invention and not for the purpose of limiting the same. In the drawings,
- Fig. 1A: shows a schematic side view of a prior art capacitive sensor with driving line and receiving line side by side under a cover without external influence;
- Fig. 1B: shows the prior art capacitive sensor of Fig. 1A under external influence by an approaching finger;
- Fig. 2: shows a schematic cross-section view of a capacitive sensor according to an embodiment of the invention;
- Fig. 3A: shows a schematic view of the capacitances equivalent circuit of the embodiment of Fig. 2 without external influence;
- Fig. 3B: shows the schematic view of the capacitances equivalent circuit of the embodiment of Fig. 2 with external influence; and
- Fig. 4: shows a schematic view form above on a further embodiment of the invention. DESCRIPTION OF PREFERRED EMBODIMENTS

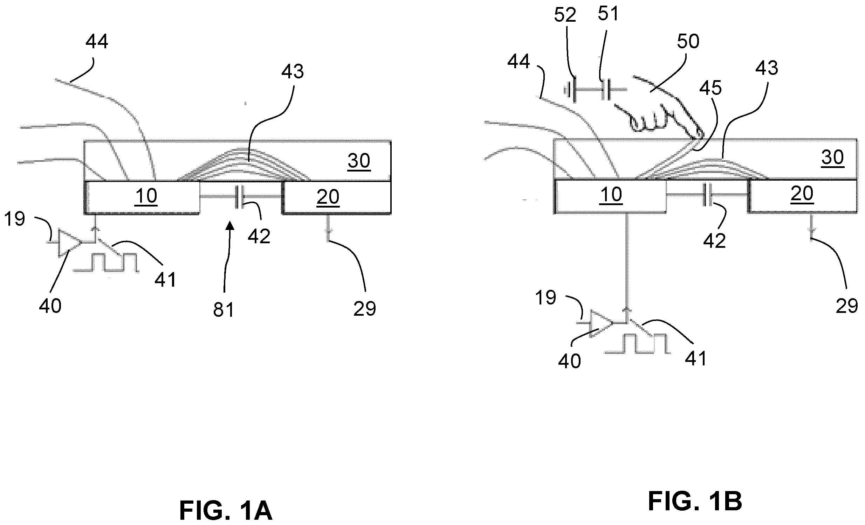

Fig. 1A shows a schematic side view of a prior art capacitive sensor with driving line 10 and receiving line 20 side by side under a cover 30 without external influence. Fig. 1B shows the prior art capacitive sensor of Fig. 1A under external influence by an approaching finger 50.

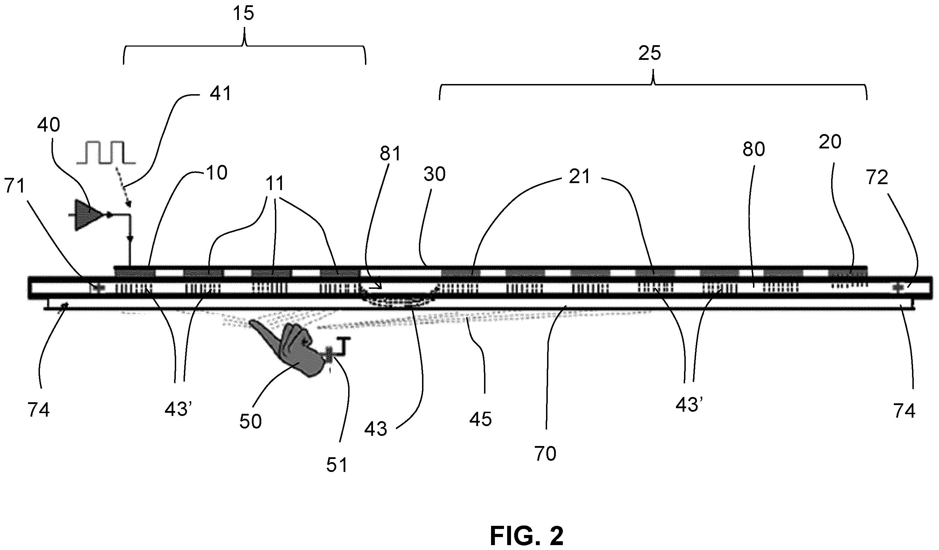

Fig. 1A shows a capacitive sensor being formed between a driving electrode 10 and a receiving electrode 20. It is explained - inter alia - with reference to reference numerals from the embodiment of a capacitive sensor as shown in Fig. 2. During the measurement, a rectangular signal 41 is applied to the driving electrode 10 and charge is transferred from the driving electrode 10 to the receiving electrode 20 over the sensor capacitance 42. Usually, the sensor electrodes 10 are imprinted on a PCB 80 (see Fig. 2) or another isolated substrate on the same conductive side and on opposite side there is either a conductive shielding plane connected to ground 52 or no metal.

The sensor capacitance value 42 depends on the sensor electrode layout, the substrate material and any material or air surrounding the driving electrode 10 and receiving electrode 20. Such a surrounding material can be a device cover 30.

Fig. 1A shows the electrical field lines 43 between the driving electrode 10 and the receiving electrode 20 without interference from an object. Fig. 1B shows the electrical field lines 43 of the same arrangement, when a finger 50 touches the sensor area. The sensor capacitance is lower in Fig. 1B because a part of the electrical field between the driving electrode 10 and the receiving electrode 20 is shunted over the body-to-ground capacitance 51 and back to the device via the device / ground capacitance. The capacitive change is sometimes mentioned to be a finger induced capacitive change, since a hand with a finger is shown in the drawings. In fact, it is an object capacitive change, since the approaching body is not necessarily a finger and, in case it is a finger, the body associated to the finger provides the connection to ground. In this respect the capacitance of the object to earth 51 is connected to ground 52.

The change in capacitance between «no touch» in Fig. 1A and «touch» in Fig. 1B depends on many parameters. For example:
- Sensor layout and architecture
- Cover material and/or substrate material properties
- Cover and/or print thickness
- Object size (e.g. finger)
- Object distance to the sensor
- Capacitance of object to ground (e.g. human body)
- Capacitance of device to ground

The influence of the material 30 covering the driving electrode 10 and the receiving electrode 20 is expressed by the dielectric constant (or relative permittivity) εr. Larger εr values result in higher capacitance values.

Fig. 2 shows a schematic cross-section view of a capacitive sensor according to an embodiment of the invention. The sensor according to Fig. 2 comprises a substrate, especially a PCB substrate 80 (rigid or flexible) (printed circuit board), with a driving electrode area 15 with several driving electrodes 10, 11 grouped in this one region 15 on the left of the sensor and with a sensing electrode area 25 with multiple sensing electrodes 20, 21 grouped in this second region 25 on the right. In between the regions 15 and 25 is the insulating separation area 81 of the PCB 80. Beside the terminology PCB, print or substrate are also used in alternance to PCB 80. The insulating separation area 81 is made of the same material as the substrate 80.

The several driving electrodes 10, 11 or several sensing electrodes 20, 21 are connected in an electrical conducting manner with e.g. traces on the PCB forming one single driving electrode and one single sensing electrode, respectively. 0-Ohm resistors or other wires can be used too.

The electro-magnetic or in short electric field between the driving electrode(s) 10, 11 and sensing electrode(s) 20, 21 are visualized in a schematic way by fictitious electric field lines 43 which are extending to all connected electrode elements 10, 20 as indicated by schematic field lines 43' between the driving and sensing plates. It is noted that the driving and sensing electrodes 10, 11, 20, 21 are shown in Fig. 2 as grey surfaces separated by insulation layer material 30. Therefore, floating plate electrode 74 could be shown with a similar grey surface filled with grey color, since the floating plate electrode is made of a conductive material, especially the same conductive material as the driving and sensing electrodes.

The printed circuit board can be a traditional insulating layer 80 with the conductive electrodes 10, 11 and 20, 21 printed on the upper surface. In the embodiment shown in Fig. 2, the conductive electrodes 10, 11 and 20, 21 are integrated within the cover layer 30 on the insulating layer 80. Cover layer 30 is not a distinctive layer (like in Fig. 1A or 1B), it is part of the top layer on a standard PCB structure. It is an isolator. This layer can be optionally opened, for example to solder components on the top conductive layer. In other embodiments, the printed circuit board can also be a multilayer laminated sandwich structure. The definitions of "upper" surface or an approaching finger (or object) "from the bottom" are only chosen for the description of and in reference to the figures, in which the driving and sensing electrodes are at the top of the device and the floating plate is positioned at the bottom of the device as shown. However, for a device in use, there is no requirement relating to a specific orientation for the use.

The electrodes 10, 11, 20, 21 are on the conductive layer which automatically is covered by layer 30 which can be an intrinsic, not distinctive, part of the top layer. Nevertheless, the electrodes can also be considered to be embedded.

Below the printed circuit board, i.e. below the conductive electrodes 10 and 20 embedded in the cover layer 30, on the bottom side of the PCB 80, a bottom floating plane 70 covers the two regions of electrodes 10 and 20, respectively. This creates a driving side capacitance 71 and a sensing side capacitance 72 since the insulating PCB layer 80 and 81 is located in between. The reference lines of the reference numerals 71 and 72 are directed towards a symbolic capacitance shown in the dielectric insulating layer 80. However, the driving side capacitance 71 and the sensing side capacitance 72 are centred on the driving side and similarly on the receiving side, respectively. Preferably, the bottom floating plane 70 comprises on both sides areas 74 extending on the left and on the right beyond the regions 15 and 25 of electrodes 10 and 20, respectively.

When the PCB 80 has more than two conductive layers, the layers on which the sensing areas 20 and the floating plane 70 are used, can be chosen as desired. It can then be stated that the floating plate 70 is on an intermediate conductive layer of the PCB.

The two regions of electrodes 10 and 20 are relatively far apart, so that any fringe capacitance 43 between the electrodes 10 and 20 is close to zero. As mentioned above, the field lines 43 should be shown as restricted to the substrate layer, since they are fictitious and cannot exist in the conductive layer 70/74.

In the «no touch» state, the resulting capacitance is formed by driving side capacitance 71 in series with sensing side capacitance 72. In this state the electrode floating plane is floating freely and is transferring charge from the driving electrode(s) 10 to the receiving electrode(s) 20.

In the «touch» state, a new capacitance, finger induced capacitance 51 (more general capacitance between human body and ground or even more general capacitance between approaching object and ground), is introduced between the two capacitances 71 and 72 mentioned above. The floating plane 70 is usually mounted on the PCB 80 and does not normally extend on the sides beyond the PCB 80 maintaining isolation layer parts (e.g. FR4 material or polyimide) between the conductive floating plane 70 being a thin metal sheet and the one or more driving and sensing electrodes 10, 20 respectively.

As mentioned above, the driving electrode(s) 10 are connected to a control unit providing the driving pulses. In a simple embodiment, it is possible that only one driving electrode 10 and one sensing electrode 20 of the electrode distribution are connected with the control unit and they are placed at a larger distance on the top layer of a PCB (rigid or flexible) 80. The control unit is connected to the driving electrodes 10 and also to the receiving electrodes 20, comprising the driver 40 and receiving electronics like an amplifier, respectively.

In view of the schematical view of Fig. 2, this sensor arrangement is sensitive to approach or touch from the side of the bottom floating plane 70. The device according to the invention can be used in any orientation.

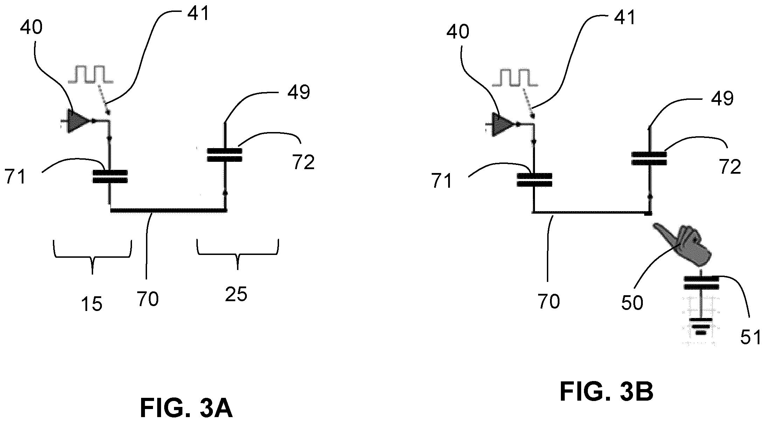

Fig. 3A shows a schematic view of the capacitances equivalent circuit of the embodiment of Fig. 2 without external influence, and Fig. 3B shows the schematic view of the capacitances equivalent circuit of the embodiment of Fig. 2 with external influence, i.e. an approaching finger 50.

Fig. 3A shows the floating plate 70 and the connecting driving side capacitance 71 and sensing side capacitance 72 and the connection to drive input 40 controlled by a control unit (not shown). It has to be seen in connection with Fig. 2 and the related features and references. Sensing side capacitance 72 of the sensing electrode 20 is connected via connection 49 to the control unit. Fig. 3B shows the same elements with the additional approaching finger 50 with the finger capacitance 51 vis-à-vis ground. This external approaching element inhibits the charge transfer from the driving electrode 10 via the floating plate 70 to the receiving electrode 20. The measured capacitance between the driving electrode 10 and the sensing electrode 20 is reduced compared to the «no touch» state.

The term 'finger capacitance' indicates the capacitance from finger 50 to floating plate 70. In view of the 'approaching' finger or an isolation layer on top of floating plate 70, there should be shown a capacitance drawn between finger 50 and plane 70, which capacitance is left out for simplicity. The finger can be any object and the capacitance at stake is the object capacitive change.

In Fig. 3B there should also be the capacitance (as in Fig 1A) from the driver to earth ground, as otherwise the loop is not closed. It is left out for simplicity.

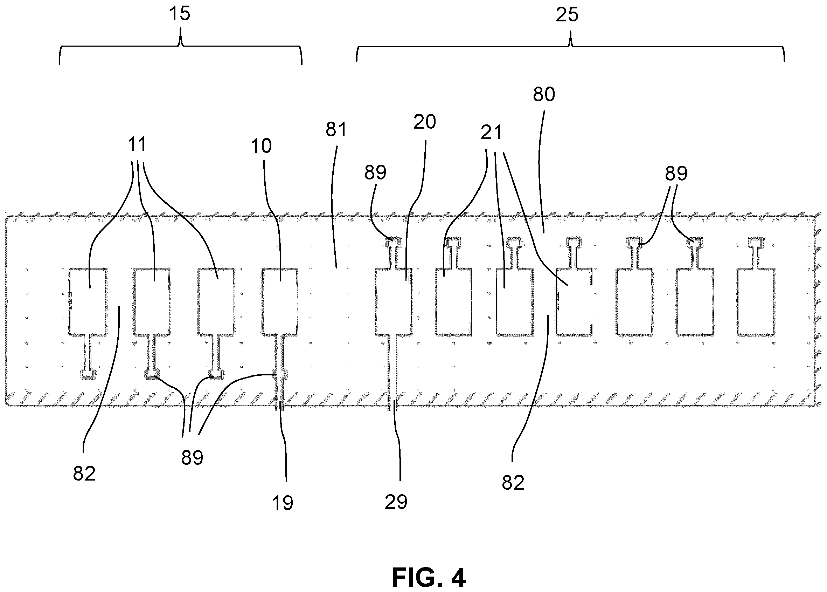

Fig. 4 shows a schematic view form above on a further embodiment of the invention. The same reference numerals are used for similar or identical features. On the substrate 80 are printed the main driving electrode 10 and the main sensing electrode 20. These electrodes are connected with traces 19 and 29 with the control unit (not shown). Trace 19 is connected with drive input 40.

To fine-tune the driving side capacitance 71 (Fig. 2) and the sensing side capacitance 72 through adjusting the basic capacitance values and thus to optimise the sensing behaviour, the main driving electrode 10 and the main sensing electrode 20 can be supplemented by several driving electrodes 11 as well as several sensing electrodes 21 provided on the printed circuit board substrate 80. This allows for increasing the electrode surfaces and thus the driving side capacitance 71 (Fig. 2) and the sensing side capacitance 72. In the embodiment of Fig. 4 all single electrodes 11 and 21 have the same size and shape. But the main electrodes 10 and 20 can be provided with a given size and the further electrodes can have a smaller size, e.g. half of the main electrodes or even provided in different sizes and shapes.

The electrodes 10, 11, 20, 21 are preferably provided side by side, separated by insulating areas 82 in between the different electrodes of the driving side and between the different electrodes of the sensing side. Insulating areas 82 can and should preferably be considerably larger than the thickness of the substrate to minimise the fringe capacitance between the electrodes. The main separation area 81 between the driving and sensing side is maintained. Any number of these electrodes 11 or 21, respectively, can be connected in parallel with solder or small 0-Ohm components or left unconnected. This can be realized e.g. via the latches 89 or openings in the passivation layer 30, as a connection to the main electrode 10 or 20, respectively, or to the control unit. In this way, the sensor has a predetermined final electrode design for the application as provided by the designer.

The main electrodes 10 and 20 can be provided as the innermost electrodes as in Fig. 4, only separated by the area 81. or they can also be the outermost electrodes (not shown in Fig. 4) with a number of connected or not connected further electrodes 11 or 21, respectively, on the driving or sensing side.

### LIST OF REFERENCE SIGNS

- 10: driving electrode
- 11: further driving electrode
- 15: driving electrode area
- 19: trace to control unit
- 20: sensing electrode
- 21: further sensing electrode
- 25: sensing electrode area
- 29: trace to control unit
- 30: cover or insulation layer
- 40: driver or driving input of the control unit input
- 41: drive signal
- 42: sensor capacitance CS
- 43: electric field
- 43': electric field
- 44: electric field
- 45: electric field influenced by approaching finger
- 49: receiving input of control unit
- 50: object / finger / hand
- 51: finger / object to earth ground capacitance
- 52: earth ground
- 70: bottom floating plate
- 71: driving side capacitance
- 72: sensing side capacitance
- 74: area of bottom plate extending on the sides beyond the electrodes
- 80: insulating layer / substrate / printed circuit board substrate
- 81: insulating separation area in the PCB between driving and sensing area
- 82: insulating separation area in the PCB between sensor parts in driving or sensing area
- 89: opening in the top passivation layer / contacting latches

## Claims

1. Capacitive sensor comprising an insulating substrate (80), wherein a flat driving electrode (10) is positioned in a driving electrode area (15) on one side of the insulating substrate (80), wherein a flat sensing electrode (20) is positioned in a sensing electrode area (25) on the same side of the insulating substrate (80), wherein the driving electrode area (15) and the sensing electrode area (25) are separated by a distancing area (81) in the plane of the insulating substrate (80), **characterized in that** an unconnected one-piece conductive plate (70) is positioned on the opposite side of the insulating substrate (80) covering a surface encompassing the driving electrode area (15) of the driving electrode (10), the sensing electrode area (25) of the sensing electrode (20) as well as the distancing area (81).

2. Capacitive sensor according to claim 1, wherein, in a view from above on the capacitive sensor, the insulating substrate (80) is extending by a predetermined distance beyond the outer edges of the driving electrode area (15) and is extending by a predetermined distance beyond the outer edges of the sensing electrode area (25).

3. Capacitive sensor according to claim 1 or 2, wherein, in a view from above on the capacitive sensor, the one-piece conductive plate (70) is extending by a predetermined distance beyond the outer edges of the driving electrode area (15) and is extending by a predetermined distance beyond the outer edges of the sensing electrode area (25).

4. Capacitive sensor according to claim 2 and 3, wherein, in a view from above on the capacitive sensor, the insulating substrate (80) is extending by a predetermined distance beyond the outer edges of the one-piece conductive plate (70).

5. Capacitive sensor according to any one of claims 1 to 4, wherein the flat driving electrode (10) and the flat sensing electrode (20) are connected (19, 29) with a control unit.

6. Capacitive sensor according to any one of claims 1 to 5, wherein a number of driving electrode parts (11) are provided in a distance (82) from the flat driving electrode (10) and from each other within the driving electrode area (15).

7. Capacitive sensor according to claim 6, that a predetermined number of the driving electrode parts (11) are connected in parallel with 0-ohms resistors, wires or traces on the same conductive layer as the electrodes (10, 11) to the flat driving electrode (10).

8. Capacitive sensor according to any one of claims 1 to 7, wherein a number of sensing electrode parts (21) are provided in a distance (82) from the flat sensing electrode (20) and from each other within the driving electrode area (25).

9. Capacitive sensor according to claim 8, that a predetermined number of sensing electrode parts (21) are connected in parallel with 0-ohms resistors, wires or traces on the same conductive layer as the electrodes (20, 21) to the flat sensing electrode (20).

10. Capacitive sensor according to any one of claims 1 to 9, wherein the insulating substrate (80) and/or the floating plate (70) is covered with an adhesive type tape or other insulating material as cover (30).

11. Capacitive sensor according to any one of claims 1 to 10, wherein the insulating substrate is a PCB (80).

12. Capacitive sensor according to claim 10, wherein, when the PCB (80) has more than two conductive layers, the sensing areas (20) and the floating plate (70) are provided in any of these layers of the PCB (80).
